# EUROPEAN PATENT APPLICATION

(11) **EP 4 514 093 A1**
(43) Date of publication of application: **26.02.2025**
(21) Application number: 24193810.9
(22) Date of filing: 09.08.2024
(51) Int. Cl.: H10D 30/69, H01L 23/00, H10D 84/85

(54) **INTEGRATED CIRCUIT WITH OVERLAPPING STRESSORS**

(30) Priority: 18.08.2023 US 202318451879
(71) Applicant: NXP USA, Inc., Austin, TX 78735 (US)
(72) Inventor: REBER, Douglas Michael, 5656AG Eindhoven (NL); SHROFF, Mehul D, 5656AG Eindhoven (NL); DEMICRAN, Ertugrul, 5656AG Eindhoven (NL)
(74) Representative: Miles, John Richard

(57) **Abstract**

An integrated circuit includes a compressive stressor and a tensile stressor, each located directly over an active region of a transistor, where a portion of the compressive stressor and a portion of the tensile stressor directly overlap with each other. In some embodiments, utilizing a compressive stressor and tensile stressor located directly over an active region with overlapping portions may allow for an adjustment of the stress applied to a channel region of a transistor to compensate for stress imparted by package structures.

## Description

### BACKGROUND OF THE INVENTION

### Field of the Invention

This invention relates in general to integrated circuits with overlapping stressors.

### Description of the Related Art

Integrated circuits utilize stressors for applying stress to the active regions of transistors to improve transistor performance. A stressor is a dielectric structure that is formed to induce a stress (either compressive or tensile) on surrounding structures of an integrated circuit. Stressors can be one of two stressor types. A compressive stressor imparts a compressive stress on a structure directly beneath the compressive stressor. Compressive stressors are formed from a dielectric material (e.g., silicon nitride) and are under a tensile stress when formed. A tensile stressor imparts a tensile stress on structures directly beneath the tensile stressor. A tensile stressor is formed from a dielectric material (e.g., silicon nitride) and is under a compressive stress when formed. Structures that are formed neither to impart a compressive or tensile stress are characterized as neutral.

With some integrated circuits that include Field-Effect Transistors (FETs), imparting a stress on the channel region can improve carrier mobility. Changing carrier mobility can affect drive current of a transistor. For a particular semiconductor substrate with a given crystal orientation, carrier mobility (e.g., electron mobility) in the channel region of an N-type FET (NFET) can be improved by imparting a tensile stress in both the longitudinal and lateral directions of the channel region. The longitudinal direction is the direction of carrier flow in the channel region and the lateral direction is laterally perpendicular to the direction of carrier flow in the channel region. For a particular semiconductor substrate with a given crystal orientation, carrier mobility (e.g., hole mobility) in the channel region of a P-type FET (PFET) can be improved by imparting a compressive stress on the channel in the longitudinal direction and a tensile stress in the lateral direction. However, with other transistors or substrates with different crystal orientations, channel stress may affect transistor performance differently.

### BRIEF DESCRIPTION OF THE DRAWINGS

The present invention may be better understood, and its numerous objects, features, and advantages made apparent to those skilled in the art by referencing the accompanying drawings.
Figure 1 is a partial cross-sectional side view of a prior art integrated circuit.
Figure 2 is a top view of a prior art integrated circuit illustrating how die terminal stress affects different areas of a substrate.
Figure 3 is a partial cross-sectional side view of an integrated circuit according to one embodiment of the present invention.
Figure 4 is a cross-sectional side view of a packaged integrated circuit according to one embodiment of the present invention.
Figure 5 is a partial cross-sectional top view of an integrated circuit according to one embodiment of the present invention.
Figure 6 is a partial cross-sectional top view of an integrated circuit according to one embodiment of the present invention.
Figure 7 is a flow chart illustrating a method for designing and making a packaged integrated circuit according to one embodiment of the present invention.

The use of the same reference symbols in different drawings indicates identical items unless otherwise noted. The figures are not necessarily drawn to scale.

### DETAILED DESCRIPTION

The following sets forth a detailed description of at least one mode for carrying out the invention. The description is intended to be illustrative of the invention and should not be taken to be limiting.

As disclosed herein, an integrated circuit includes a compressive stressor and a tensile stressor, each located directly over an active region of a transistor, where a portion of the compressive stressor and a portion of the tensile stressor directly overlap with each other. In some embodiments, utilizing a compressive stressor and tensile stressor located directly over an active region with overlapping portions may allow for an adjustment of the stress applied to a channel region of a transistor to compensate for stress imparted by package structures.

In one embodiment, utilizing overlapping stressors of opposite stressor types to compensate for the stress of package structures on the channel region of a transistor may provide stress adjustment without utilizing extra masks (e.g., for selective ion implantation or forming extra structures).

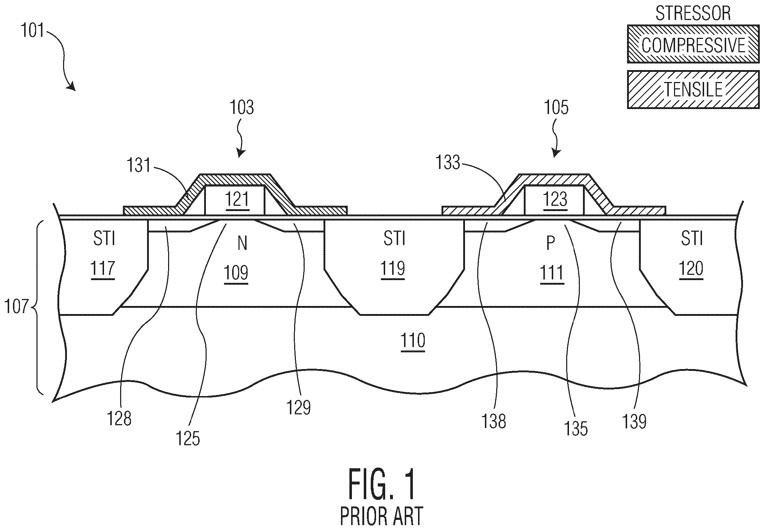

Figure 1 is a partial cross-sectional side view of a prior art integrated circuit 101. Figure 1 shows a PFET 103 and an NFET 105, each including an active region located in a substrate 107. Not shown in Figure 1 are interconnect layers located above the structures shown in Figure 1 that include conductive interconnects, vias, and die terminals and include intervening dielectric material. PFET 103 includes a gate 121 located over an active region located between shallow trench isolation (STI) structures 117 and 119, and also includes a P-type source region 128, a P-type drain region 129, and an N-type well (N-well) region 109. A conductive channel region 125 is formed between source region 128 and drain region 129 in well region 109 directly below gate 121 when a voltage is applied to gate 121 that is below the threshold voltage of PFET 103.

NFET 105 includes a gate 123 located over an active region located between shallow trench isolation structures 119 and 120 that includes an N-type source region 138, an N-type drain region 139, and a P-type well (P-well) region 111. A conductive channel region 135 is formed between source region 138 and drain region 139 in well region 111 when a voltage is applied to gate 121 that is above the threshold voltage of NFET 105.

A compressive stressor 131 is located directly over PFET 103 and is made of a patterned layer of silicon nitride that is under a tensile stress. Stressor 131 imparts a desired amount of compressive stress on channel region 125 in the direction of carrier flow to increase carrier flow during transistor conductivity.

A tensile stressor 133 is located directly over NFET 105 and is made of a patterned layer of silicon nitride that is under a compressive stress. Stressor 133 imparts a desired amount of tensile stress in channel region 135 in the direction of carrier flow to increase the carrier flow during transistor conductivity.

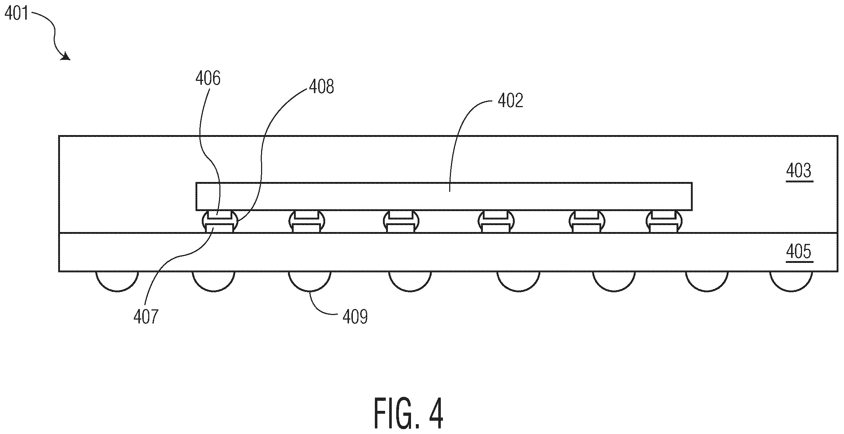

Stressors 131 and 133 are configured, e.g., size, position, thickness, and amount of internal stress, to impart a desired amount of stress on the channel region to improve carrier mobility in the transistor. However, other package structures (not shown in Figure 1) of a packaged integrated circuit implementing integrated circuit 101, such as metal interconnect structures in the die interconnect layers, external die terminals (e.g., bond pads, pillars, bumps), metal plates, solder, packaging boards, and package encapsulate (see Figure 4), may also impart a stress on the channel region that can counter or add to the stress provided by stressors 131 and 133 such that the desired amounts of stress are not provided to the channel regions. Furthermore, the stress caused by packaged structures is not necessarily uniform across the integrated circuit, but may be dependent upon the distances of the package structures to the channel region. Because the compressive stressors may be patterned from a single layer and the tensile stressors may be patterned from a single layer, the parameters for the layer to have a desired stress cannot be altered to account for variations of package structure stress due to location. Accordingly, transistor mobility may vary based on transistor location in the integrated circuit. Such a variation in carrier mobility may lead to a drive current variation based on transistor location. Such a variance is undesirable for proper integrated circuit operation.

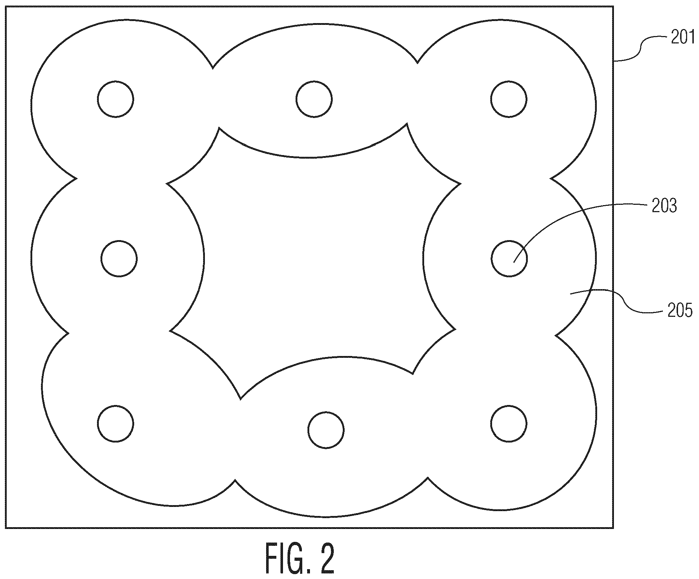

Figure 2 is a top view of an integrated circuit 201 showing areas of stress variation on the channel regions due to external die terminals (e.g., bond pads, pillars, posts). The smaller identified areas (e.g., 203) in Figure 2 represent the approximate locations of the external die terminals where the maximum amount of stress affects the channel regions of transistors in those areas. The areas 205 surrounding the smaller areas represent areas of moderate stress from the external die terminals. As shown in Figure 2, the stress due to a die terminal tends to decrease with increased distance away from the terminal. The stress of an external die terminal not only includes the stress imparted by the die terminal structures themselves but also from the stress of other packages structures mechanically coupled to the terminal. Also, the amount of stress imparted by a die terminal may be dependent upon the location of the die terminal. For example, corner die terminals may impart a greater stress on a substrate than internal die terminals.

An active region of a transistor includes the regions in the substrate of semiconductor material for the terminals of the transistor (e.g., current terminals and control terminals if present in the substrate) and semiconductor pathways that conduct carriers between the terminals of the transistor. For a FET, the active area would include the source region, the drain region, and the channel region.

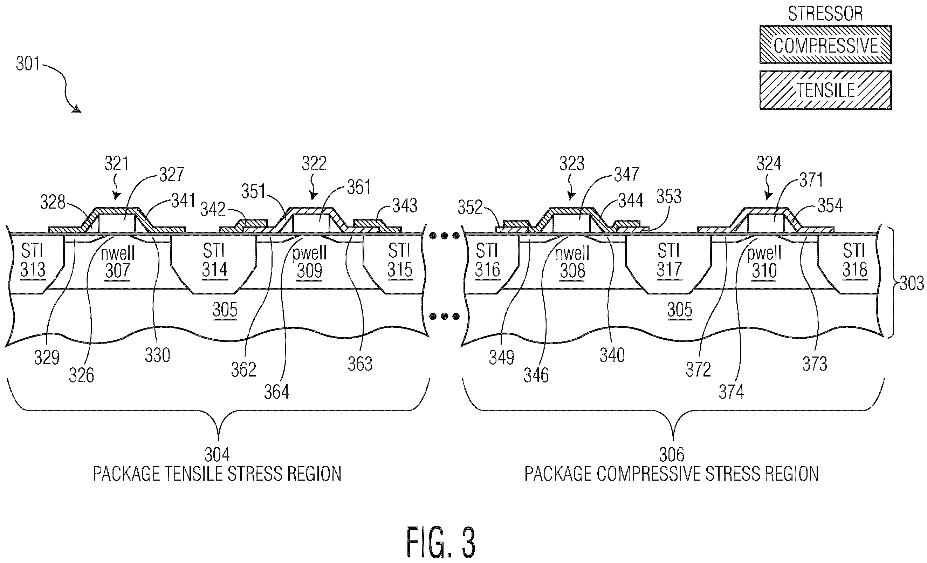

Figure 3 is a partial cross-sectional side view of an integrated circuit 301 according to one embodiment of the present invention. Integrated circuit 301 includes PFETs 321 and 323 and NFETs 322 and 324, where each transistor includes an active region located in substrate 303.

Substrate 303 is made of one or more semiconductor materials such as e.g., monocrystalline silicon, silicon germanium, gallium nitride, gallium arsenide, or other III-V semiconductor materials. In one embodiment, substrate 303 has a bulk semiconductor configuration. In other embodiments, substrate may have an SOI (semiconductor on insulator) configuration. In some embodiments, substrate 303 is formed from a singulated portion of an integrally grown semiconductor material. In other embodiments, portions of substrate 303 may include epitaxially grown semiconductor material. Substrate 303 also includes dielectric structures (e.g., shallow trench isolation structure (STI) 313). In the embodiment shown, transistors 321-324 are planar transistors. However, in other embodiments, transistors 321-324 are characterized as FinFETs where the cross-sectional view of Figure 3 cuts longitudinally through a semiconductor fin.

Not shown in Figure 3 are the interconnect layers located above the structures shown in Figure 3 that include conductive interconnects, vias, terminal contacts, and die terminals (e.g., pads, post, bumps) and includes intervening dielectric material that provides electrical isolation of these conductive structures. The conductive structures of the interconnect layers provide conductive paths between the terminal regions of the transistors and to both other devices of integrated circuit 301 and circuitry external to integrated circuit 301.

Substrate 303 includes regions formed by the selective doping of P-type dopants (e.g., boron) and N-type dopants (phosphorus, arsenic) that are located over base substrate layer 305. A "P-type" region has a net P-type doping concentration. An "N-type" region has a net N-type doping concentration.

PFET 321 includes a gate 327 located over an active region located between shallow trench isolation structures (STI) 313 and 314 that includes a P-type source region 329, P-type drain region 330, and an N-type well region 307. A conductive channel region 326 is formed between source region 329 and drain region 330 in well region 307 directly below gate 327 when a voltage is applied to gate 327 that is below the threshold voltage of PFET 321.

NFET 322 includes a gate 361 located over an active region located between shallow trench isolation structures 314 and 315 that includes a N-type source region 362, an N-type drain region 363, and a P-type well region 309. A conductive channel region 364 is formed between source region 362 and drain region 363 in well region 309 when a voltage is applied to gate 361 that is above the threshold voltage of NFET 322.

PFET 323 includes a gate 347 located over an active region located between shallow trench isolation structures 316 and 317 that includes a P-type source region 349, a P-type drain region 340, and an N-type well region 308. A conductive channel region 346 is formed between source region 349 and drain region 340 in well region 308 directly below gate 347 when a voltage is applied to gate 347 that is below the threshold voltage of PFET 323.

NFET 324 includes a gate 371 located over an active region located between shallow trench isolation structures 317 and 318 that includes an N-type source region 372, an N-type drain region 373, and a P-type well region 310. A conductive channel region 374 is formed between source region 372 and drain region 373 in well region 310 when a voltage is applied to gate 371 that is above the threshold voltage of NFET 324. Not shown in Figure 3 are body contact regions for transistors 321-324.

A compressive stressor 328 is located directly over PFET 321 to provide channel region 326 with a compressive stress in the longitudinal direction. A compressive stressor 344 is located directly over PFET 323 to provide channel region 346 with a compressive stress in the longitudinal direction. A tensile stressor 351 is located directly over NFET 322 to provide channel region 364 with a tensile stress in the longitudinal direction. A tensile stressor 354 is located directly over NFET 324 to provide channel region 374 with a tensile stress in the longitudinal direction. In one embodiment, stressors 328, 351, 344, and 354 serve as etch stop layers for forming source and drain contacts (not shown).

PFET 321 and NFET 322 are located in an area 304 of integrated circuit 301 that is subject to a tensile stress from package structures (e.g., interconnects, die terminals, solder, encapsulant). Accordingly, compressive stressors 342 and 343 are located over portions of the active area of NFET 322 (e.g., source region 362 and drain region 363, respectively) to reduce the stress effect of tensile stressor 351 so as to provide the desired amount of tensile stress to channel region 364. Else, a greater amount of tensile stress than desired would be imparted on channel region 364 due to the tensile stress applied by the packaging structures.

A stressor of one stressor type (e.g., compressive stressor 342) overlapping a stressor of the other stressor type (e.g., tensile stressor 351) acts to reduce the amount of stress provided by the other stressor. The amount of channel stress reduction of a second stressor is dependent upon the amount of overlap and the location of the overlap respect to the channel. The closer the overlapped portion to the channel, the greater the stress reduction. Also, the greater then overlap portion, the greater the stress reduction.

PFET 323 and NFET 324 are located in an area 306 of integrated circuit 301 that is subject to a compressive stress from package structures. Accordingly, tensile stressors 352 and 353 are located over portions of the active area of PFET 323 (e.g., source region 349 and drain region 340, respectively) to reduce the stress effect of compressive stressor 344 so as to provide the desired amount of compressive stress to channel region 364. Else, a greater amount of compressive stress in channel 346 than desired would be imparted on channel 346 due to the compressive stress applied by the packaging structures.

In the embodiment shown, compressive stressors 341, 342, 343, and 344 are formed from a layer of dielectric material whose processes, parameters, and materials are as selected to provide a dielectric layer that is formed to have a desired tensile stress. In one embodiment, the dielectric layer is a silicon nitride layer formed from a plasma enhanced chemical vapor deposition process with 524 MPa stress after annealing. Typical process conditions are with gas flow rates of 1960 sccm Nitrogen, 40 sccm Silane, 55 sccm Ammonia with 55mW/cm2 13.56MHz power. Afterwards, the layer is selectively patterned to form the compressive stressors 341, 342, 343, and 344. However, in other embodiments, the compressive stressor may be formed by other methods and/or of other materials in other embodiments.

In the embodiment shown, tensile stressors 351, 352, 353, and 354 are formed from a layer of dielectric material whose processes, parameters, and materials are as selected to provide a dielectric layer that is formed to have a compressive stress. In one embodiment, the dielectric layer includes silicon nitride and is formed from a plasma enhanced chemical vapor deposition process with -506 MPa stress after annealing. Typical process conditions are with gas flow rates of 1500 sccm Nitrogen, 100 sccm Silane, and no Ammonia with 165mW/cm2 0.308MHz power. Afterwards, the layer is selectively patterned to form the tensile stressors 351, 352, 353, and 354. However, in other embodiments, the tensile stressors may be formed by other methods and/or of other materials in other embodiments.

In one embodiment, the stressors are utilized as etch stop layers for forming contacts (not shown) to contact the source regions, the drain regions, and the gates of transistors 321-324. With such an embodiment, after forming the stressors, a blanket dielectric layer (e.g., oxide) (not shown) is formed over the wafer and planarized. Afterwards, patterned openings are formed in the oxide layer and in the stressors to contact silicide (not shown) on the gates, source regions, and drain regions of the transistors. The openings are filled with one or more conductive contact materials and then planarized to form contacts (not shown).

In the embodiment shown, the tensile stressors 351, 352, 353, and 354 are formed before compressive stressors 341, 342, 343, and 344. However, in other embodiments, the compressive stressors may be formed before the tensile stressors. In the embodiment shown, all of the tensile stressors are formed from a single layer and all of the compressive stressors are formed from a single layer. However, in other embodiments, the compressive stressors may be formed from different layers and the tensile stressors may be formed from different layers.

In one embodiment, the compressive stressors and the tensile stressors may be made of different dielectric materials that are etch selective with respect to each other (e.g., silicon nitride and silicon oxynitride). Thus, the subsequently formed stressor layer can be etched without etching the initially formed stressors. However, in other embodiments, the initially formed stressors would include a capping layer (e.g., oxide) that is of an etch selectable material from the subsequently formed stressor layer. Thus, the subsequently formed stressor layer can be etched with an anisotropic etch without etching the previously formed stressors.

In one embodiment, the layer for forming the compressive stressors is designed to provide a desired amount of compressive stress to a PFET in a region of the integrated circuit that is under the most tensile stress from packaging structures. For PFETs that are located in areas of less tensile packaging stress to areas of more compressive packaging stress, tensile stressors (e.g., 352 and 353) can be added over the active regions of the PFETs to reduce the amount of compressive stress provided by the compressive stressors (e.g., 344). In this way, the amount of compressive stress provided to a PFET channel can be "tuned" to offset variations in stress due to packaging structures at different locations.

Likewise, in one embodiment, the layer for forming the tensile stressors is designed to provide a desired amount of tensile stress to an NFET in a region of the integrated circuit that is under the most compressive stress from packaging structures. For NFETs that are located in areas of less compressive packaging stress to areas of more tensile packaging stress, compressive stressors (e.g., 342 and 343) can be added over the active regions of the NFETs to reduce the amount of tensile stress provided by the tensile stressors (e.g., 351). In this way, the amount of tensile stress provided to an NFET channel can be "tuned" to offset variations in stress due to packaging structures at different locations.

In some prior art integrated circuits, stressors can be relaxed in certain areas by the selectively implanting dopants into those areas to decrease the amount of stress provided by those stressors. However, such a stress adjusting method would require at least one extra mask and extra implanting steps. With the processes described herein, stressor tuning can be accomplished with the use of existing processes (the formation of the tensile stressors and compressive stressors). However, in some embodiments, ion implantation may be further used to tune the stressors in conjunction with overlapping stressors.

In other embodiments, the transistors may be of other transistor types, have other structures, and/or be formed by other methods. For example, in some embodiments, adjacent transistors may share current terminals regions or gate structures such as where two transistors are connected in series. Also in some embodiments, a stressor located over one transistor may be contiguous with a stressor located over another transistor.

Figure 4 is a cross-sectional side view of a packaged integrated circuit 401 according to one embodiment of the present invention. Integrated circuit 402 includes a substrate with multiple transistors formed therein. Integrated circuit 402 includes die terminals (e.g., pads 406) located on one side (e.g., the bottom side in the view of Figure 4) of integrated circuit 402. In the embodiment shown, the die pads 406 are electrically attached to package board pads 407 of package board 405. Package board 405 includes embedded conductors (not shown) to electrically couple board pads 407 to solder balls 409. Integrated circuit 402 is encapsulated in an encapsulant 403. Other integrated circuit packages may have other structures or configuration in other embodiments. For example, in some embodiments, a packaged integrated circuit may be oriented with die pads 406 facing upward and include wire bonds (not shown). In other embodiments, a packaged integrated circuit may include a lead frame (not shown).

In addition to the stress caused by die pads 406, stress can also be generated on the substrate by package board 405, package pads 407, and solder 408 though the die pads 406 as well as by encapsulant 403. Accordingly, the use of different types of stressors for each transistor can tune the stress induced in a channel region to adjust for the stress provided by the package structures that may be location dependent in an integrated circuit.

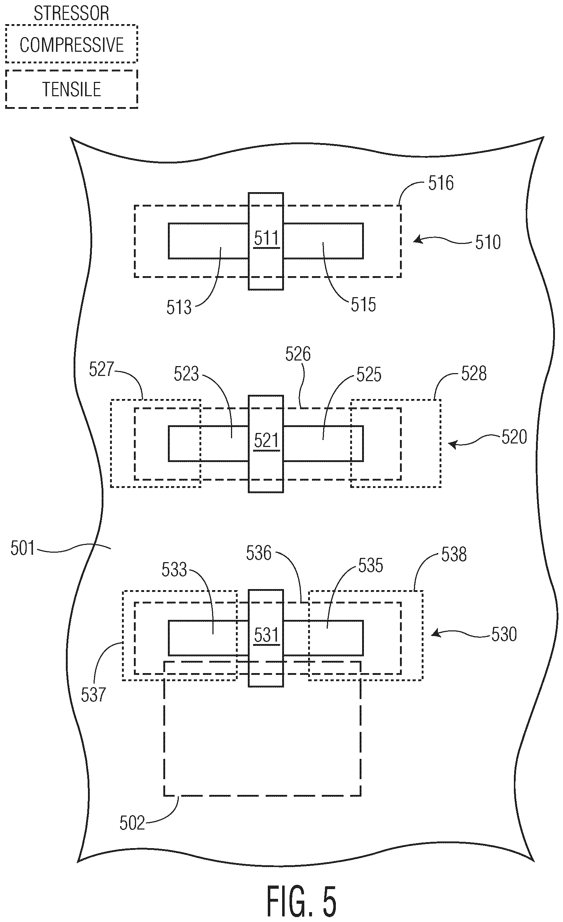

Figure 5 shows a cutaway top view of an integrated circuit 501 showing how additional stressors of an opposite stressor type can be used to tune the amount of stress provided to a channel region of a transistor to accommodate for stress induced by package structures.

Integrated circuit 501 includes three NFETs 510, 520, and 530 located laterally at various distances from area 502 where a die pad (not shown) is located directly above. NFET 510 includes a source region 513, a drain region 515, and a gate 511 located over the substrate. A channel region (not shown) is located directly under gate 511 between source region 513 and drain region 515. A tensile stressor 516 is located directly over NFET 510 in an area shown by a dashed line. NFET 520 includes a source region 523, a drain region 525, and a gate 521 located over the substrate. A channel region (not shown) is located directly under gate 521 between source region 523 and drain region 525. A tensile stressor 526 is located directly over NFET 520 in an area shown by a dashed line. Compressive stressor 527 is located directly over stressor 526 and source region 523 and compressive stressor 528 is located directly over stressor 526 and drain region 525. NFET 530 includes a source region 533, a drain region 535, and a gate 531 located over the substrate. A channel region (not shown) is located directly under gate 531 between source region 533 and drain region 535. A tensile stressor 536 is located directly over NFET 530 in an area shown by a dashed line. Compressive stressor 537 is located directly over stressor 536 and source region 533 and compressive stressor 538 is located directly over stressor 536 and drain region 535.

The pad located over area 502 imparts a tensile stress in the substrate in areas laterally surrounding area 502. The magnitude of the tensile stress decreases as the lateral distance from area 502 increases. Accordingly, the amount of overlap of the compressive stressors 537 and 538 with tensile stressor 536 in the active area of NFET 530 is greater than the amount of overlap of compressive stressors 527 and 528 with tensile stressor 526 over the active area of transistor 520 so as to provide more of an offset compressive stress in the channel region of NFET 530 than in the channel region of NFET 520. Transistor 510 includes no compressive stressor overlap with tensile stressor 516 in that it is located furthest away from area 502 where the stress of the die pad has little effect on the channel region of NFET 510. Compressive stress from package structures may be compensated by overlapping stressors in a similar manner for PFETs.

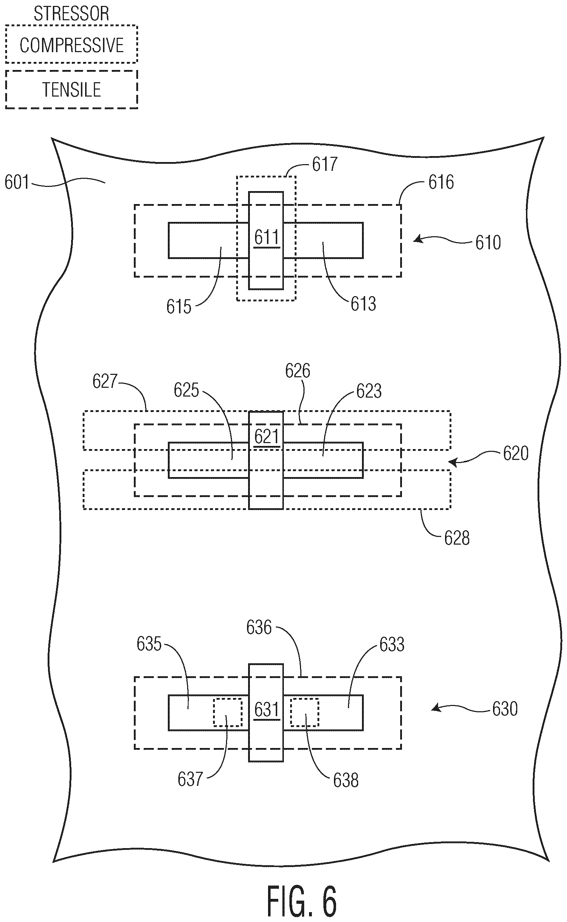

Figure 6 shows a cutaway top view of an integrated circuit 601 illustrating how different configurations of a stressor of the opposite stressor type can be used to adjust the stressor of the other stressor type. As shown below, the opposing stressor type can have various shapes and locations to reduce the stress provided by the primary stressor. In the embodiment of Figure 6, the tensile stressor is shown as the primary stressor. However, in other embodiments, the compressive stressor is the primary stressor and the tensile stressor(s) are the secondary stressors to reduce the stress of the primary stressor. Not shown in Figure 6 are the contact openings in the stressors for the source, drain, and gate contacts.

NFET 610 includes a source region 615, a drain region 613, a gate 611 located over the substrate. A channel region (not shown) is located directly under gate 611 between source region 615 and drain region 613. A tensile stressor 616 is located directly over NFET 610 in an area shown by a dashed line. A compressive sensor 617 is located directly over stressor 616, gate 611, source region 615, and drain region 613 to reduce the tensile stress provided by tensile stressor 616 in the channel region.

NFET 620 includes a source region 625, a drain region 623, and a gate 621 located over the substrate. A channel region (not shown) is located directly under gate 621 between source region 625 and drain region 623. A tensile stressor 626 is located directly over NFET 620 in an area shown by a dashed line. Compressive sensors 627 and 628 are located directly over stressor 626, gate 621, source region 625, and drain region 623 to reduce the tensile stress provided by tensile stressor 626 in the channel region.

NFET 630 includes a source region 635, a drain region 633, and a gate 631 located over the substrate. A channel region (not shown) is located directly under gate 631 between source region 635 and drain region 633. A tensile stressor 636 is located directly over NFET 630 in an area shown by a dashed line. Compressive stressor 637 is located directly over stressor 636 and source region 635. Compressive stressor 638 is located over stressor 636 and drain region 633.

Although the embodiment of Figure 6 describes where the tensile stressors are formed first, in other embodiments, the compressive stressors are formed first. Also, in other embodiments, the stressors may have other configurations and/or be located at different areas of the active area for countering the stress of a primary stressor.

In the embodiments shown, one primary stressor covers the entire active area of a transistor and a stressor of the opposite stressor type overlaps with the primary stressor to reduce the stress imparted by the primary stressor. However, in other embodiments, no single stressor may cover the entire active area. For example, NFET 520 of Figure 5 could be modified such that the lateral ends of source region 523 and drain region 525 would not be covered by stressor 526. However, compressive stressors 527 and 528 would still overlap the edges of tensile stressor 526 to insure that the active area is covered for contact formation.

In some embodiments, it may be desirable to use overlapping stressors of opposite types to tune a transistor of a symmetric device pair to match the performance device characteristics of the other transistor of the symmetric pair. Such use of overlapping stressors may provide for an improved performance of circuits with symmetric device pair.

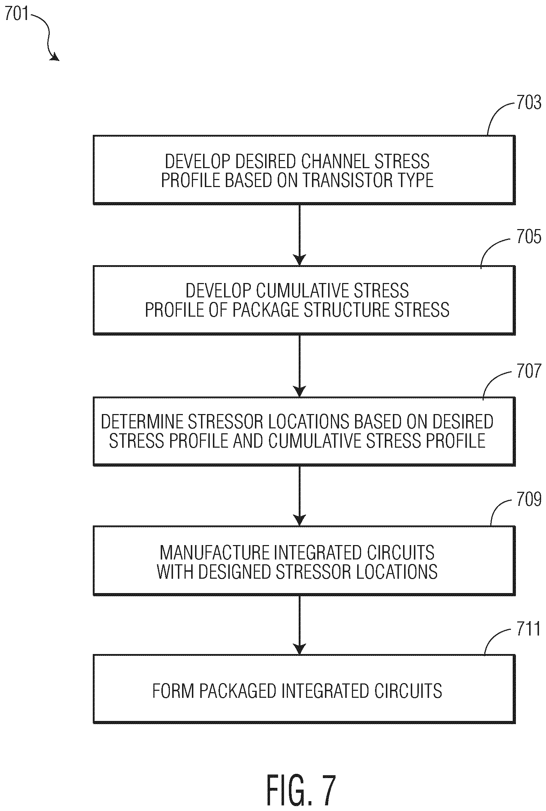

Figure 7 is a flow chart illustrating a method 701 for designing and making a packaged integrated circuit according to one embodiment of the present invention. Method 701 begins by developing a desired channel stress profile for the transistors of an integrated circuit in operation 703. In one embodiment, for each transistor, the desired channel stress profile developed is based on the conductivity type of the transistor (e.g., N-type or P-type), the size of the transistor, and the desired drive current of the transistor.

In operation 705, a profile of the cumulative stress effects of the package structures on the substrate of an integrated circuit is developed. The profile indicates the cumulative package structure stress at each channel location of the integrated circuit. In one embodiment, operation 705 may be performed prior to operation 703.

At operation 707, a placement plan of the compressive stressors and tensile stressors is developed based on the desired stress profile developed in operation 703 and the package structure stress profile developed in operation 705 The stressors are placed in locations to provide the desired stress in the channels of each transistor compensating for the package stress on the channel at each location. The plan is implemented in the wafer mask set and process recipes for making the wafer of the integrated circuit. Operations 703, 705, and 707 may be performed with computer-aided design (CAD) tools used for integrated circuit design.

In operation 709, integrated circuits are manufactured to have the designed stressor locations. In one embodiment, the stressors and transistors are formed on a wafer that is then singulated to form multiple integrated circuits. In operation 711, the integrated circuits are packaged to form packaged integrated circuits. An integrated circuit with overlapping stressors may be designed and made by other processes in other embodiments.

An integrated circuit includes a compressive stressor and a tensile stressor, each located directly over an active region of a transistor, where a portion of the compressive stressor and a portion of the tensile stressor directly overlap with each other. In some embodiments, utilizing a compressive stressor and tensile stressor located directly over an active region with overlapping portions may allow for an adjustment of the stress applied to a channel region of a transistor to compensate for stress imparted by package structures.

As shown and described herein, providing an integrated circuit with overlapping stressors of different stressor types may allow for the stresses of the channel regions of an integrated circuit to be individually adjusted based on the cumulative package structure stress at different locations of an integrated circuit.

In addition, utilizing overlapping stressors for channel stress tuning may allow for the use of only one stressor layer of each stressor type to be utilized for different sizes of transistors of the same conductivity type that require different channel stress levels. For example, if the channel regions of two different NFETs of different transistor sizes require different tensile stress levels, the same layer can be used as a tensile stressor for both transistors, wherein the transistor of the channel of the lower desired tensile stress level would include more area of overlapping stressors. Thus, the number of layer formation and patterning operations may be reduced.

A source region and a drain region are current terminal regions for a FET and a gate is a control terminal for a FET.

As disclosed herein, a first structure is "directly over" a second structure if the first structure is located over the second structure in a line having a direction that is perpendicular with a generally planar major side of the wafer or substate. For example, in Figure 3, stressor 351 is directly over P-well 309. Stressor 341 is not directly over P well 309. As disclosed herein, a first structure is "directly beneath" or "directly under" a second structure if the first structure is located beneath the second structure in a line having a direction that is perpendicular with a generally planar major side of the wafer or substrate. For example, in Figure 3, N well 308 is directly beneath stressor 344. N well 308 is not directly beneath stressor 354. One structure is "directly between" two other structures in a line if the two structures are located on opposite sides of the one structure in the line. For example, in Figure 3, stressor 342 is located directly between gates 327 and 361 in a line in the cut away side view of Figure 3. STI 314 is not located directly between gates 327 and 361 in a line. A first structure is "directly lateral" to a second structure if the first structure and second structure are located in a line having a direction that is parallel with a generally planar major side of the wafer or substrate. For example, gate 327 and gate 361 are directly lateral to each other. One structure is "directly laterally between" two other structures if the two structures are located on opposite sides of the one structure in a line that is parallel with a generally planar major side of the wafer or substrate. For example, in Figure 3, stressor 342 is located directly laterally between gates 327 and 361. Two structures directly overlap each other if one of the two structures is directly over the other of the two structures in a line having a direction that is perpendicular with a generally planar major side of the wafer or substrate. For example, stressor 342 and stressor 351 directly overlap. A surface is at a "higher elevation" than another surface, if that surface is located closer to the top of the active side of a wafer or integrated circuit in a line having a direction that is perpendicular with the generally planar major side of the wafer or integrated circuit. In the view of Figure 3, the active side of integrated circuit 301 is the top side of the Figure 3. For example, gate 361 is at a higher elevation than STI 314.

Features specifically shown or described with respect to one embodiment set forth herein may be implemented in other embodiments set forth herein.

In a first aspect, an integrated circuit includes a first transistor including an active region, a first stressor of a first stressor type located directly over the active region, and a second stressor of a second stressor type opposite the first stressor type located directly over the active region, wherein the first stressor and the second stressor each includes a portion that directly overlaps each other.

In some embodiments, the first stressor and the second stressor each include a portion that directly overlaps each other directly over the active region. In some embodiments, the first stressor and the second stressor each include a portion that directly overlaps each other directly over a current terminal region of the first transistor. In some embodiments, the first stressor and the second stressor each include a portion that directly overlaps each other directly over a channel region of the first transistor. In some embodiments, the integrated circuit further comprises a third stressor of the second stressor type located directly over the active region, wherein the first stressor and the third stressor each include a portion that directly overlaps each other. The first stressor may include a portion that does not directly overlap the third stressor. In some embodiments, the transistor is characterized as FET and the second stressor is located directly over a source region in the active region of the first transistor and not directly over a drain region of the first transistor, the third stressor is located directly over the drain region of the first transistor and not directly over the source region of the first transistor. In some embodiments, the first stressor includes a portion that does not directly overlap with a portion of the second stressor. In some embodiments, the first stressor is located directly over the entire active area, wherein the second stressor is not located directly over the entire active area. In some embodiments, the first stressor is located directly over the second stressor. In some embodiments, the second stressor is located directly over the first stressor. In some embodiments, the integrated circuit further comprises: a second transistor including a second active region, the second transistor being of the same conductivity type as the first transistor; a third stressor of a first stressor type located directly over the second active region; a fourth stressor of the second stressor type located directly over the second active region, wherein the third stressor and the fourth stressor each include a portion that directly overlaps each other. In some embodiments, the active region is a same size as the second active region; an area of the overlap of the first stressor and the second stressor is greater than an area of overlap of the third stressor and the fourth stressor. In some embodiments, the integrated circuit further comprising: a die terminal located in a first area of the integrated circuit, wherein the second active region is laterally located at a greater lateral distance from the first area than the active region. Embodiments of the integrated circuit may be included in a packaged integrated circuit. In some embodiments, the first stressor and the second stressor each include silicon nitride. In some embodiments, the first transistor includes a gate structure, wherein the first stressor is located directly over the gate structure and the second stressor is not located directly over the gate structure. In some embodiments, the first stressor is made of a first material and the second stressor is made of a second material that is etch selectable from the first material. In some embodiments, the first stressor serves as an etch stop layer for forming a terminal contact of the first transistor.

In another aspect, an integrated circuit includes a first field-effect transistor (FET) including an active region, a first stressor of a first stressor type located directly over the active region, and a second stressor of a second stressor type opposite the first stressor type located directly over the active region. The first stressor and the second stressor each include a portion that directly overlaps each other over the active region of the FET, wherein the first stressor includes a portion that does not directly overlap with a portion of the second stressor.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the true spirit and scope of this invention.

## Claims

1. An integrated circuit comprising:
a first transistor including an active region;
a first stressor of a first stressor type located directly over the active region;
a second stressor of a second stressor type opposite the first stressor type located directly over the active region, wherein the first stressor and the second stressor each includes a portion that directly overlaps each other.

2. The integrated circuit of claim 1 wherein the first stressor and the second stressor each include a portion that directly overlaps each other directly over the active region.

3. The integrated circuit of any preceding claim wherein the first stressor and the second stressor each include a portion that directly overlaps each other directly over a current terminal region of the first transistor.

4. The integrated circuit of any preceding claim wherein the first stressor and the second stressor each include a portion that directly overlaps each other directly over a channel region of the first transistor.

5. The integrated circuit of any preceding claim further comprising a third stressor of the second stressor type located directly over the active region, wherein the first stressor and the third stressor each include a portion that directly overlaps each other.

6. The integrated circuit of claim 5 wherein the first stressor includes a portion that does not directly overlap the third stressor.

7. The integrated circuit of claim 5 or 6 wherein:
the transistor is characterized as FET;
the second stressor is located directly over a source region in the active region of the first transistor and not directly over a drain region of the first transistor, the third stressor is located directly over the drain region of the first transistor and not directly over the source region of the first transistor.

8. The integrated circuit of any preceding claim wherein the first stressor includes a portion that does not directly overlap with a portion of the second stressor.

9. The integrated circuit of any preceding claim wherein the first stressor is located directly over the entire active area, wherein the second stressor is not located directly over the entire active area.

10. The integrated circuit of claim 9 wherein the first stressor is located directly over the second stressor.

11. The integrated circuit claim 9 wherein the second stressor is located directly over the first stressor.

12. The integrated circuit of any preceding claim further comprising:
a second transistor including a second active region, the second transistor being of the same conductivity type as the first transistor;
a third stressor of a first stressor type located directly over the second active region;
a fourth stressor of the second stressor type located directly over the second active region, wherein the third stressor and the fourth stressor each include a portion that directly overlaps each other.

13. The integrated circuit of claim 12 further wherein:
the active region is a same size as the second active region;
an area of the overlap of the first stressor and the second stressor is greater than an area of overlap of the third stressor and the fourth stressor.

14. The integrated circuit of claim 13 further comprising:
a die terminal located in a first area of the integrated circuit, wherein the second active region is laterally located at a greater lateral distance from the first area than the active region.

15. A packaged integrated circuit including the integrated circuit of any preceding claim.
